# EUROPEAN PATENT SPECIFICATION

(11) **EP 3 631 851 B1**
(45) Date of publication and mention of the grant of the patent: **14.08.2024**
(21) Application number: 17742843.0
(22) Date of filing: 31.05.2017
(51) Int. Cl.: H01L 23/367

(54) **HEAT SINK STRUCTURE**
KÜHLKÖRPERSTRUKTUR
STRUCTURE DE DISSIPATEUR THERMIQUE

(43) Date of publication of application: 08.04.2020
(73) Proprietor: Agile POWER SWITCH 3D - INTEGRATION aPSI3D, 65000 Tarbes (FR); IRT Antoine de Saint Exupery, 31405 Toulouse CEDEX 4 (FR); Institut Catholique d'Arts et Metiers, 31300 Toulouse (FR)
(72) Inventor: FAVRE, Jacques Pierre Henri, 31400 Toulouse (FR); REYNES, Jean-Michel Francis, 81600 Gaillac (FR); FRADIN, Jean-Pierre Bernard Marie, 31150 Bruguieres (FR); CADILE, Claudia, 31200 Toulouse (FR); LACABANNE, Renaud André, 65000 Tarbes (FR)
(74) Representative: DeltaPatents B.V.
(86) International application number: PCT/IB2017/000837
(87) International publication number: WO 2018/220417

(56) References cited:
- US-A- 5 168 348
- US-A- 5 535 515
- US-A1- 2002 139 515
- US-A1- 2011 297 361
- US-A1- 2016 341 492
- US-B1- 6 208 513
- US-B1- 9 644 907

## Description

### Field of the Invention

The present invention relates to a heat sink structure. More in particular, the present invention relates to a heat sink structure comprising heat sink parts, such as fins or ribs.

### Background of the Invention

Heat sinks are well known, in particular in the field of electronics. Electronic components, such as processors and power switches, produce heat when in use. Such components may not radiate enough heat to keep their temperature within a normal working range. For this reason, a heat sink may be mounted on the component. A heat sink may consist of a metal structure having elements which serve to lead the heat away from the component.

United States patent US 4 884 331, for example, discloses a unitary heat sink apparatus for removal of heat from a heat generating component, such as a semiconductor device. The heat sink apparatus has a heat sink body or base portion from which parallel fins extend outwardly, the fins being separated by grooves produced by sawing.

United States patent US 6 807 059 discloses a pin fin heat sink manufactured by fusion or stud welding of fins to a base. The base is shown to be constituted by a single large plate supporting a large number of pin fins, in one embodiment 256 pin fins.

Such prior art arrangement are useful when the electronic component on which they are to be mounted have a sufficiently flat top surface which allows a good thermal contact with the heat sink. However, in practice the top surfaces of electronic components are often not perfectly flat, which results in a less than perfect heat transfer. In addition, the top surface of the electronic component may become distorted as the component heats up, thus reducing the heat transfer even when the initial heat transfer was good.

US20110297361A1 describes a low stress-inducing heat sink which is said to have in-plane flexibility and hence reduce thermally induced stress and strain generated in the heat source and at the interface of the heat sink and the heat source. The heat sink comprises in one embodiment a fin grid with a mesh of connecting struts.

US5535515 describes a heatsink assembly which comprises a flexible support element having an upper surface and a lower surface. A number of metal heat-conductive elements, with one end being substantially flat, are embedded in the support element so that the upper portions of the heads are laterally surrounded by the flexible support element.

US20160341492A1 describes a heat sink in which cylindrical bodies are provided in a standing manner on a supporting plate.

### Summary of the Invention

It is an object of the present invention to solve this problem by providing a heat sink structure comprising a plurality of heat sink parts, each heat sink part having a contact area for contacting a surface of an electronic device, the heat sink parts being spaced apart so as to allow them to adjust and keep the contact areas contacting the surface of the electronic device when the surface is distorted.

By providing a plurality of heat sink parts which are spaced apart, the heat sink structure is better suited to adjust to the surface of the electronic device. In particular, as the heat sink parts are spaced apart, they are capable of altering their mutual positions so as to adjust the heat sink structure to the electronic component. When the surface of the electronic component is distorted due to heat generation and/or other causes, this adjustment of the heat sink structure allows the contact areas of the heat sink parts to remain in contact with the surface of the electronic component.

The heat sink structure of the invention therefore comprises multiple spaced apart contact areas. Being spaced apart, for example being separated by gaps, allows those contact areas to absorb changes in the surface of the electronic component. In the prior art, however, a heat sink structure has a single, relatively large contact area, typically the bottom surface of a base plate, which is not capable of absorbing changes in the surface of the electronic component. By providing spaced apart heat sink parts, and hence spaced apart contact areas, a more flexible heat sink structure is obtained.

The contact area of a heat sink element of the invention may be located at an side or end of the heat sink part, and may be equal to a side surface or end surface of the heat sink part.

The heat sink elements are not connected. That is, there may be no direct connection between the heat sink elements of the heat sink structure, the heat sink elements only being mechanically connected through the electronic component on which they are mounted.

A heat sink part may therefore be constituted by a number of heat sink elements which are not connected, or by a combination of one or more rib-like elements and heat sink elements which are not connected.

The contact areas of the heat sink parts may define a common plane, that is, a plane which is common to those contact areas, all contact areas substantially lying in the common plane.

Although the heat sink elements may be solid, in some embodiments at least one heat sink element is hollow. A hollow heat sink element has a reduced weight and an increased surface area, and may therefore be advantageous.

At least one heat sink elements may be a pin heat sink element, that is, a heat sink element shaped like a pin. At least one heat sink part may be rib-shaped. A heat sink part may be hollow, solid or partially hollow.

At least one heat sink part may have an undulating shape. Such a shape increases the surface area of the heat sink part, thus improving the heat sinking capabilities of the structure.

In embodiments of the invention, the heat sink parts extend substantially in parallel, preferably substantially perpendicular to a common plane. In some embodiments, however, the heat sink parts may not be parallel and may, for example, each have a different angle with respect to a common plane. In such embodiments, the heat sink parts and/or heat sink elements may diverge in the direction from the contact areas.

The invention further provides an electronic device, provided with a heat sink structure as described above. The electronic device, which may comprise a power switch, is provided with a surface, such as a top surface, for mounting a heat sink structure. The electronic device may further comprise a housing and electrical contacts extending from the housing.

In the above, the heat sink structure was referred to as being mounted, or capable of being mounted, on an electronic component, such as a power switch. In some embodiments, the electronic component may be mounted on the heat sink structure, or the heat sink structure may be arranged for mounting an electronic component. In some embodiments, the component may not be an electronic component but an optical component, for example, or an electro-optical component.

### Brief description of the drawings

The present invention will further be explained with reference to exemplary embodiments illustrated in the drawings, in which:
Fig. 1 schematically shows a first embodiment of a heat sink structure.
Fig. 2 schematically shows a second embodiment of a heat sink structure.
Fig. 3 schematically shows a third embodiment of a heat sink structure.
Fig. 4 schematically shows a fourth embodiment of a heat sink structure.
Fig. 5 schematically shows a fifth embodiment of a heat sink structure.
Fig. 6 schematically shows a sixth embodiment of a heat sink structure.
Fig. 7 schematically shows a seventh embodiment of a heat sink structure.
Fig. 8 schematically shows a eighth embodiment of a heat sink structure.
Fig. 9 schematically shows a ninth embodiment of a heat sink structure.
Fig. 10 schematically shows a tenth embodiment of a heat sink structure.
Fig. 11 schematically shows a eleventh embodiment of a heat sink structure.
Fig. 12 schematically shows a twelfth embodiment of a heat sink structure.
Fig. 13 schematically shows a first embodiment of an electronic device provided with heat sink structures.
Fig. 14 schematically shows a second embodiment of an electronic device provided with heat sink structures.

### Detailed description of embodiments

The present invention provides a heat sink structure which includes a number of heat sink parts. Each heat sink part may have a contact area for contacting a surface of an electronic device, such as an electronic switch or amplifier. The heat sink parts are spaced apart. This may allow the heat sink parts to adjust their mutual positions so as to keep their contact areas contacting the surface of the electronic device when this surface is distorted, for example due to heat development.

The heat sink parts of the invention may have various shapes and sizes. In some embodiments, a heat sink part may comprise a number of heat sink elements, such as pins. A row of pins may be connected by a connecting member, thus forming a longitudinal heat sink part. In some embodiments, such a longitudinal heat sink part may be constituted by a plate or rib instead of a connected row of pins. In some embodiments, the plate may be undulating. Longitudinal heat sink parts may be connected to each other, for example at their ends. However, the heat sink parts are still separated by gaps, which allows the heat sink parts a degree of relative movement to adjust to distortions of a surface on which the heat sink structure may be mounted.

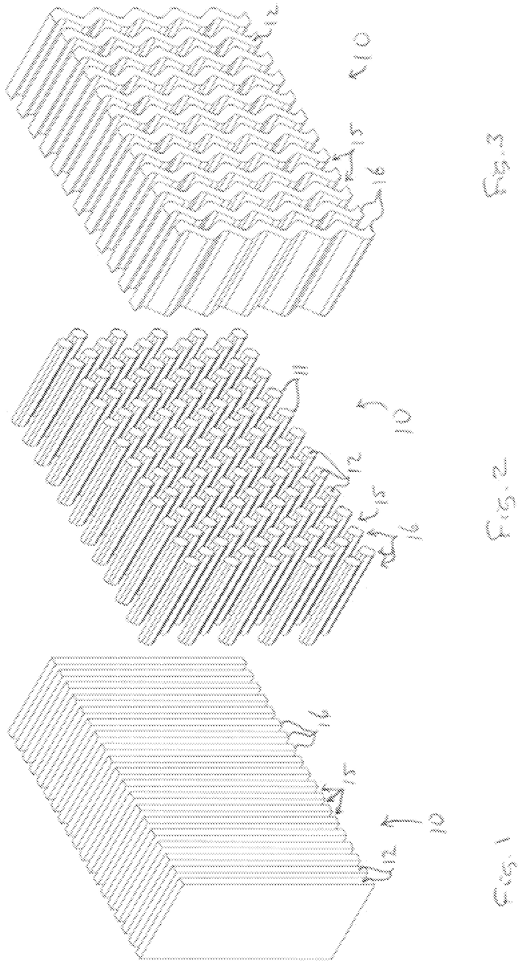

The embodiments as shown in Figs. 1-9, 13, 14 by themselves do not fall within the scope of the claimed invention as they omit a guide structure and are presented for illustration purposes only.

In the embodiment of Fig. 1, the heat sink structure 10 is shown to comprise a series of heat sink parts 16 separated by gaps 15. In this embodiment, the heat sink parts 16 are constituted by plates which are not connected to each other. The spacings or gaps 15 allow a relative movement of the plates, in particular in a direction perpendicular to their contact surfaces 12. As shown in Fig. 1, the contact surfaces 12 are in this embodiment constituted by the sides of the plate-shaped heat sink parts 16, in particular the longer sides of the rectangular plates. It will be understood that in other embodiments, the shorter sides of rectangular plates may be used as contact surfaces for contacting the electronic device. In yet other embodiments, the substantially flat heat sink parts may be square.

The contact surfaces 12 may lie approximately in a common plane, at least initially. It will be understood that the surface on which the heat sink structure 10 is mounted, or at least the surface which the heat sink structure 10 abuts, may or may not initially be flat, and may distort as the surface heats up. That is, an initially flat surface may become curved or may deviate from a flat surface in another manner, for example by showing undulations, local depressions or local protrusions. Embodiments can be envisaged in which the surface of the electronic device is initially not flat but curved, for example.

In the embodiment of Fig. 1, the heat sink parts 16 are not connected to each other. They may be held in place by being mounted on the electronic device (not shown in Fig. 1), for example by gluing. Alternatively, or additionally, their positions may be determined by support members (not shown), for example comb-shaped support members of which the teeth are located between the plates. It will be understood that the spacings or gaps 15 between the heat sink parts 16 not only allow relatively movement of the heat sink parts, but also allow air to be passed between the heat sink parts.

In the embodiment of Fig. 2, the heat sink parts 16 are not constituted by plates but by rows of heat sink elements 11. In this embodiment, the heat sink elements 11 are round and elongate elements which may also be referred to as pins. Each heat sink element 11 has a contact surface 12, which in this embodiment is approximately circular.

The embodiment of Fig. 2 offers the advantage of allowing more relatively movement, as the heat sink parts 16 are each made up of separate heat sink element 11. Thus not only the heat sink parts 16 (here: the rows of pins) but also the heat sink elements 11 (here: the pins) may move slightly as the surface of the electronic device changes shape. It will be understood that this relative movement will be primarily in the longitudinal direction of the pins, although some lateral movement of the pins may also be possible. Although the pins or heat sink elements 11 are shown to be all parallel, their angles relative to the surface of the electronic device need not be all the same and may in some embodiments change during use.

As in the embodiment of Fig. 1, the heat sink elements 11 are not connected to each other. They may be held in place by being mounted on the electronic device (not shown in Fig. 2), for example by gluing. Alternatively, or additionally, their positions may be determined by suitable support members (not shown), for example a plate having circular holes for accepting the pins. Such a plate may be made of metal of plastic, for example.

The embodiment of Fig. 3 is similar to the embodiment of Fig. 1 with the exception of the shape of the plate-like heat sink parts 16. While the heat sink parts 16 in the embodiment of Fig. 1 are substantially straight, the heat sink parts 16 in the embodiment of Fig. 3 are undulating: the plates have a wave-like surface. As a result, the contact surfaces 12 are have a meandering or winding shape. The undulating shape of the heat sink parts 16 increases their surface are and thereby improves their heat sinking capabilities.

In the embodiments of Fig. 3 the heat sink parts 16 are also not connected directly to each other, as in the embodiments of Fig. 1 and 2.

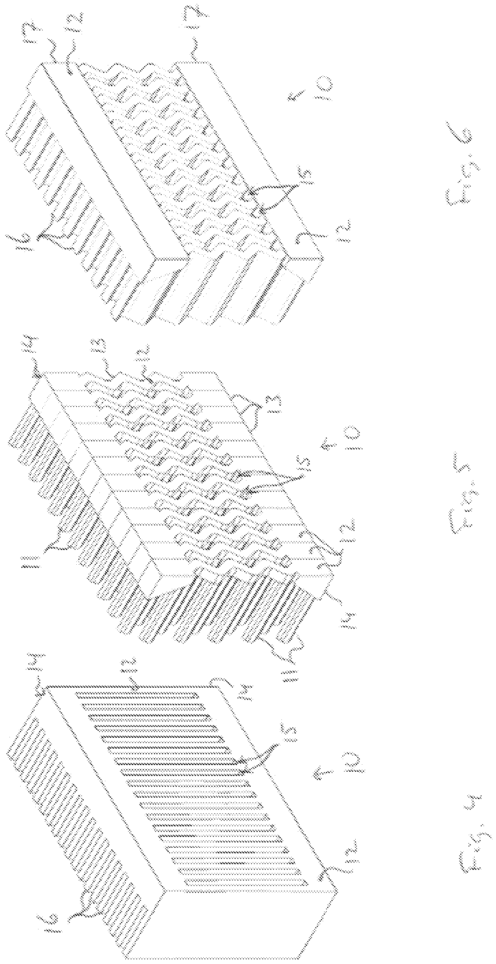

In the embodiment of Fig. 4, the heat sink parts 16 are essentially identical to the heat sink parts 16 of Fig. 1 and are also constituted by plates. The plates are joined at their end sections 14 (seen in the longitudinal direction of the plates) to form a single, integrated heat sink structure 10. In according with the invention, the plates or heat sink parts 16 are separated by gaps 15 which space the heat sink parts 16 apart. In the embodiment shown in Fig. 4, the gaps 15 extend over a substantial part of the length of the plate-shaped heat sink parts 16, that is, over approximately 70% of their length. To achieve the desired flexibility of the heat sink structure, the gaps should extend over at least 60% of the length of the heat sink parts, but preferably over at least 70%. In some embodiments, the gaps 15 may extend over between 80% and 95% of the length of the plates. In the embodiment of Fig. 1 the plates are not connected at their ends, thus achieving 100%. In the embodiment of Fig. 4, the contact areas 12 of the heat sink parts 16 are constituted by the sides of the plates, as well as by the connecting areas at the end sections 14. In this embodiment, the sides are integral with the areas of the end sections where the plates are connected to each other.

The embodiment of Fig. 5 differs from the embodiment of Fig. 4 in that the heat sink parts 16 are constituted by rows of pin-shaped heat sink elements 11, as in the embodiment of Fig. 2. In the embodiment shown in Fig. 5, five pin-shaped heat sink elements 11 are connected by a connecting member 13, thus proving the heat sink parts 16 which are arranged in parallel and are separated by gaps 15. Each connecting member 13 has a side surface which constitutes the contact area 12 of the heat sink part 16. At their end sections 14, the connecting members 13 are wider. This allows the connecting members 13 to contact each other at their end sections 14 while leaving the gaps or spacings 15 between the major part of their lengths. The connection members 13 may only touch each other at their end sections 14, thus allows relative movement of the heat sink parts. Alternatively, the end sections 14 of the connecting members 13 may be connected to each other, for example by gluing, thus forming a single heat sink structure 10.

In the embodiment of Fig. 5, the pins or heat sink elements 11 can be said to have an indirect thermal connection with the contact areas 12, through the connecting members 13. It is recalled that in the embodiment of Fig. 1 the heat sink elements 11 have a direct thermal connection with their contact areas, as in that embodiment the contact areas are the end surfaces of the pins, and the connecting members 13 are absent.

A further embodiment is schematically illustrated in Fig. 6, where the heat sink parts 16 are constituted by undulating plates, as in the embodiment of Fig. 3. It will be understood that in this embodiment, as in the embodiment of Fig. 4, no distinct connecting members 13 are present. The undulating plate-like heat sink parts 16 of Fig. 6 are shown to be connected at their end sections 14 by transverse members 17 but are for more than 50% of their length separated by gaps 15. As in the other embodiments, these spacings or gaps 15 allow some degree of adjustment of the heat sink parts 16 relative to each other, such that the contact areas 12 can remain in contact with the surface of an electronic component, even when that surface distorts in use. Surfaces of the transverse members 17 constitute the contact surfaces 12 in this embodiment.

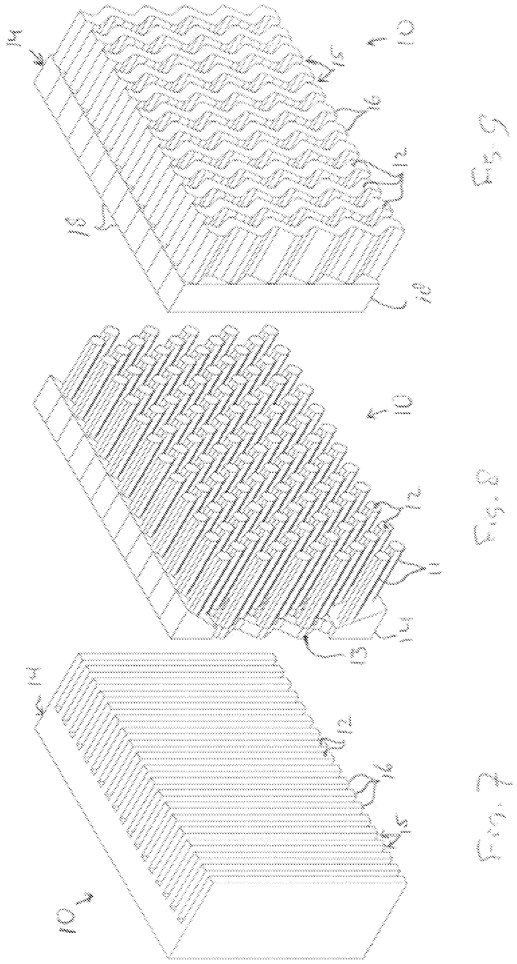

The embodiment of Fig. 7 is similar to the one of Fig. 4 but is reversed: the contact areas 12 are located on the sides of the heat sink parts 16 which are furthest away from the end sections 14. Compared to the embodiment of Fig. 4, this embodiment may provide a better adaptation to a distortion of the surface of the electronic device, as the gaps or spacings 15 extend over the full length of the heat sink parts 16. Still, this heat sink structure 10 is an integral structure.

The embodiment of Fig. 8 is similar to the one of Fig. 5 but is also reversed: the contact areas 12 are located on the sides of the heat sink elements 11 which are furthest away from the connecting members 13 and the end sections 14. Compared to the embodiment of Fig. 5, this embodiment may provide a better adaptation to a distortion of the surface of the electronic device.

The embodiment of Fig. 9 is similar to a reversed version of the one of Fig. 5: the contact areas 12 are located on the sides of the heat sink parts 16 which are furthest away from the end sections 14. Compared to the embodiment of Fig. 6, this embodiment may provide a better adaptation to a distortion of the surface of the electronic device. In contrast to the embodiment of Fig. 6, this embodiment includes base members 18 which are similar to the connection members 13 of Fig. 5 but have a uniform width. The parallel base members 18 may or may not be connected to each other.

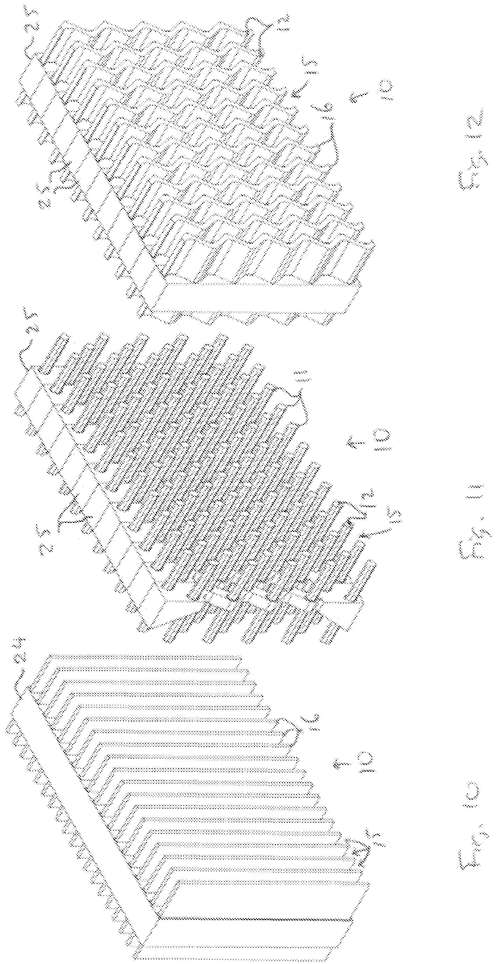

The embodiment of Fig. 10 is substantially identical to the embodiment of Fig. 1, with the exception of the added guide structure 24 which serves to position the heat sink parts 16. This guide structure 24 may have suitable slots for accepting the heat sink parts 16, and may be made of metal or plastic. The guide structure 24 may be removed once the heat sink structure 10 is mounted on the electronic device. In some embodiments, the guide structure 24 may remain in place during use of the heat sink structure 10.

Similarly, the embodiment of Fig. 11 is substantially identical to the one of Fig. 2, with the exception of the added guide members 25, which together constitute a guide structure. The guide members 25 of this embodiment are shown to have round openings in which the heat sink elements 11 may slidingly fit so as to position the heat sink elements on the surface of the electronic device. After positioning ,the guide members 25 may be removed, although in some embodiments they may remain in place. The guide members 25 may be separate components or may be connected (for example by gluing) to form a single guide structure.

The embodiment of Fig. 12 is essentially identical to the embodiment of Fig. 3, with the exception of the addition of guide members 25. The guide members of Fig. 12 have suitable openings for accepting the heat sink parts 16 having a meandering shape. The guide members 25 may be separate members or may be joined to form a single guide structure, and may or may not be removed after mounting the heat sink structure on the electronic device.

It is noted that the contact areas 12 shown in Figs. 1 to 12 are substantially flat. However, this is not essential and embodiments can be envisaged in which the contact areas 12 are curved, for example, to accommodate a curved surface of an electronic device. Still, the gaps between the heat sink elements or heat sink parts allow some relative movement and therefore some adjustment to changes in the surface of the electronic device. In this way, a distortion of the surface of the electronic component will not degrade the thermal contact between the electronic component and the heat sink structure.

In some embodiments, at least some heat sink elements and/or heat sink parts may be hollow. Thus, hollow pins and/or hollow plates may be used. In some embodiments, at least some heat sink elements may be solid. That is, solid pins and/or solid plates may be used.

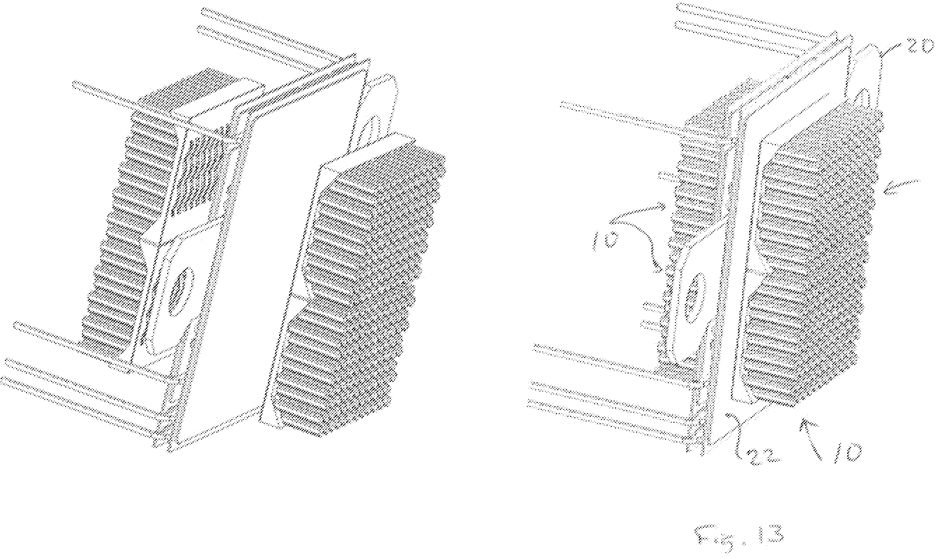

Fig. 13 schematically shows an electronic device provided with heat sink structures. The electronic device 20 (of which only electrical terminals are clearly visible) is accommodated between four heat sink structures 10, two on each side. The electronic device 20 is provided with surfaces 22 on which the heat sink structures 10 are mounted. The electronic device 20 may be an electronic power switch, for example.

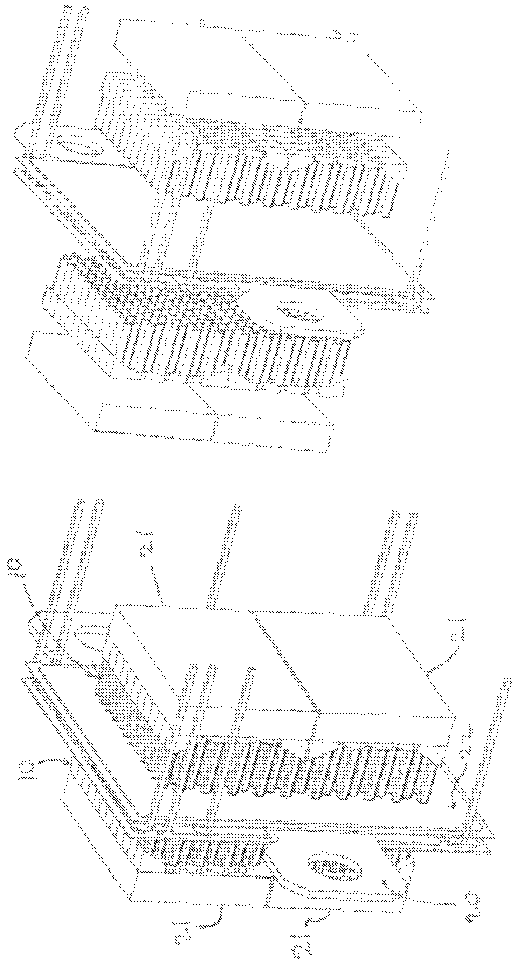

Fig. 14 also shows an electronic device 20 provided with heat sink structures 10. The heat sink structures 10 are mounted on surfaces 22 of the electronic device 20. In this embodiment, PCM (Phase Change Material) reservoirs 21 are mounted on the heat sink structures 10. In some embodiments, the heat sink structure may have a base which may serve as a PCM reservoir for receiving PCM material (or, more in general, diphasic material).

Accordingly, an electronic device may be provided with a heat sink structure according to the invention. The electronic device may, for example, be a power switch, but may also be an amplifier, rectifier or other electronic device.

It will be understood that the description of the invention given above is not intended to limit the invention in any way. Singular nouns and the articles "a" and "an" are of course not meant to exclude the possibility of plurals. Devices mentioned in this document may be replaced with their successors, even if these successors are not yet known at the time of writing. The abstract should never be used to limit the scope of the claims, and neither should reference numbers in the claims.

It will further be understood by those skilled in the art that the present invention is not limited to the embodiments mentioned above and that many additions and modifications are possible without departing from the scope of the invention as defined in the appending claims. members 25 of this embodiment are shown to have round openings in which the heat sink elements 11 may slidingly fit so as to position the heat sink elements on the surface of the electronic device. After positioning ,the guide members 25 may be removed, although in some embodiments they may remain in place. The guide members 25 may be separate components or may be connected (for example by gluing) to form a single guide structure.

The embodiment of Fig. 12 is essentially identical to the embodiment of Fig. 3, with the exception of the addition of guide members 25. The guide members of Fig. 12 have suitable openings for accepting the heat sink parts 16 having a meandering shape. The guide members 25 may be separate members or may be joined to form a single guide structure, and may or may not be removed after mounting the heat sink structure on the electronic device.

It is noted that the contact areas 12 shown in Figs. 1 to 12 are substantially flat. However, this is not essential and embodiments can be envisaged in which the contact areas 12 are curved, for example, to accommodate a curved surface of an electronic device. Still, the gaps between the heat sink elements or heat sink parts allow some relative movement and therefore some adjustment to changes in the surface of the electronic device. In this way, a distortion of the surface of the electronic component will not degrade the thermal contact between the electronic component and the heat sink structure.

In some embodiments, at least some heat sink elements and/or heat sink parts may be hollow. Thus, hollow pins and/or hollow plates may be used. In some embodiments, at least some heat sink elements may be solid. That is, solid pins and/or solid plates may be used.

Fig. 13 schematically shows an electronic device provided with heat sink structures according to the invention. The electronic device 20 (of which only electrical terminals are clearly visible) is accommodated between four heat sink structures 10, two on each side. The electronic device 20 is provided with surfaces 22 on which the heat sink structures 10 are mounted. The electronic device 20 may be an electronic power switch, for example.

Fig. 14 also shows an electronic device 20 provided with heat sink structures 10 according to the invention. The heat sink structures 10 are mounted on surfaces 22 of the electronic device 20. In this embodiment, PCM (Phase Change Material) reservoirs 21 are mounted on the heat sink structures 10. In some embodiments, the heat sink structure may have a base which may serve as a PCM reservoir for receiving PCM material (or, more in general, diphasic material).

Accordingly, an electronic device may be provided with a heat sink structure according to the invention. The electronic device may, for example, be a power switch, but may also be an amplifier, rectifier or other electronic device.

It will be understood that the description of the invention given above is not intended to limit the invention in any way. Singular nouns and the articles "a" and "an" are of course not meant to exclude the possibility of plurals. Devices mentioned in this document may be replaced with their successors, even if these successors are not yet known at the time of writing. The abstract should never be used to limit the scope of the claims, and neither should reference numbers in the claims.

It will further be understood by those skilled in the art that the present invention is not limited to the embodiments mentioned above and that many additions and modifications are possible without departing from the scope of the invention as defined in the appending claims.

## Claims

1. A kit of parts comprising:
- a heat sink structure (10) comprising a plurality of heat sink parts (16), each heat sink part having a contact area (12) for contacting a surface (22) of an electronic device (20), the heat sink parts being spaced apart and not directly connected to each other,
- a guide structure (24, 25) to position the heat sink parts (16) relative to the surface (22) of the electronic device (20), **characterized in that** the guide structure (24, 25) comprises respective openings for accepting and providing a sliding fit for the respective heat sink parts (16) to enable positioning the heat sink parts (16) on the surface (22) of the electronic device (20).

2. The kit of parts according to claim 1, wherein a heat sink part (16) comprises at least two heat sink elements (11).

3. The kit of parts according to claim 2, wherein at least one heat sink element (11) is hollow.

4. The kit of parts according to any of claims 2 to 3, wherein at least one heat sink element (11) is a pin heat sink element.

5. The kit of parts according to any of the preceding claims, wherein at least one heat sink part (16) is hollow.

6. The kit of parts according to any of the preceding claims, wherein at least one heat sink part (16) is a rib heat sink element.

7. The kit of parts according to claim 6, wherein at least one heat sink part (16) has an undulating shape.

8. The kit of parts according to any of the preceding claims, wherein the heat sink parts (16) extend substantially in parallel.

9. Electronic device provided with a heat sink structure (10) and a guide structure (24, 25) according to any of the preceding claims.

10. A method of mounting a heat sink structure to a surface of an electronic device, comprising:
- providing the heat sink structure, the heat sink structure comprising a plurality of heat sink parts, each heat sink part having a contact area for contacting the surface of the electronic device, the heat sink parts being spaced apart and not directly connected to each other;
- providing a guide structure to position the heat sink parts relative to the surface of the electronic device, the guide structure comprising respective openings for accepting and providing a sliding fit for the respective heat sink parts;
- using the guide structure to position the heat sink parts of the heat sink assembly on the surface of the electronic device.

11. The method according to claim 10, further comprising removing the guide structure once the heat sink structure is mounted on the electronic device.

## Patentansprüche

1. Ein Kit aus Teilen, umfassend:
- eine Kühlkörperstruktur (10), die eine Vielzahl von Kühlkörperteilen (16) umfasst, wobei jedes Kühlkörperteil einen Kontaktbereich (12) zum Kontaktieren einer Oberfläche (22) einer elektronischen Vorrichtung (20) aufweist, wobei die Kühlkörperteile voneinander beabstandet und nicht direkt miteinander verbunden sind,
- eine Führungsstruktur (24, 25) zum Positionieren der Kühlkörperteile (16) relativ zu der Oberfläche (22) der elektronischen Vorrichtung (20), **dadurch gekennzeichnet, dass** die Führungsstruktur (24, 25) jeweilige Öffnungen zum Aufnehmen und Bereitstellen einer Gleitpassung für die jeweiligen Kühlkörperteile (16) umfasst, um ein Positionieren der Kühlkörperteile (16) auf der Oberfläche (22) der elektronischen Vorrichtung (20) zu ermöglichen.

2. Das Kit aus Teilen nach Anspruch 1, wobei ein Kühlkörperteil (16) mindestens zwei Kühlkörperelemente (11) umfasst.

3. Das Kit aus Teilen nach Anspruch 2, wobei mindestens ein Kühlkörperelement (11) hohl ist.

4. Das Kit aus Teilen nach einem der Ansprüche 2 bis 3, wobei mindestens ein Kühlkörperelement (11) ein Stiftkühlkörperelement ist.

5. Das Kit aus Teilen nach einem der vorstehenden Ansprüche, wobei mindestens ein Kühlkörperteil (16) hohl ist.

6. Das Kit aus Teilen nach einem der vorstehenden Ansprüche, wobei mindestens ein Kühlkörperteil (16) ein Rippenkühlkörperelement ist.

7. Das Kit aus Teilen nach Anspruch 6, wobei mindestens ein Kühlkörperteil (16) eine gewellte Form aufweist.

8. Das Kit aus Teilen nach einem der vorstehenden Ansprüche, wobei sich die Kühlkörperteile (16) im Wesentlichen parallel erstrecken.

9. Eine elektronische Vorrichtung, die mit einer Kühlkörperstruktur (10) und einer Führungsstruktur (24, 25) nach einem der vorstehenden Ansprüche bereitgestellt ist.

10. Ein Verfahren zum Montieren einer Kühlkörperstruktur an einer Oberfläche einer elektronischen Vorrichtung, umfassend:
- Bereitstellen der Kühlkörperstruktur, wobei die Kühlkörperstruktur eine Vielzahl von Kühlkörperteilen umfasst, wobei jedes Kühlkörperteil einen Kontaktbereich zum Kontaktieren der Oberfläche der elektronischen Vorrichtung aufweist, wobei die Kühlkörperteile voneinander beabstandet und nicht direkt miteinander verbunden sind;
- Bereitstellen einer Führungsstruktur zum Positionieren der Kühlkörperteile relativ zu der Oberfläche der elektronischen Vorrichtung, wobei die Führungsstruktur jeweilige Öffnungen zum Aufnehmen und Bereitstellen einer Gleitpassung für die jeweiligen Kühlkörperteile umfasst;
- Verwenden der Führungsstruktur, um die Kühlkörperteile der Kühlkörperbaugruppe auf der Oberfläche der elektronischen Vorrichtung zu positionieren.

11. Das Verfahren nach Anspruch 10, das weiter das Entfernen der Führungsstruktur umfasst, sobald die Kühlkörperstruktur auf der elektronischen Vorrichtung montiert ist.

## Revendications

1. Un kit de parties comprenant :
- une structure de dissipateur thermique (10) comprenant une pluralité de parties de dissipateur thermique (16), chaque partie de dissipateur thermique présentant une zone de contact (12) pour entrer en contact avec une surface (22) d'un dispositif électronique (20), les parties de dissipateur thermique étant espacées et non directement reliées entre elles,
- une structure de guidage (24, 25) pour positionner les parties de dissipateur thermique (16) par rapport à la surface (22) du dispositif électronique (20), **caractérisé en ce que** la structure de guidage (24, 25) comprend des ouvertures respectives pour accepter et assurer un ajustement coulissant des parties de dissipateur thermique respectives (16) pour permettre le positionnement des parties de dissipateur thermique (16) sur la surface (22) du dispositif électronique (20).

2. Le kit de parties selon la revendication 1, dans lequel une partie de dissipateur thermique (16) comprend au moins deux éléments de dissipateur thermique (11).

3. Le kit de parties selon la revendication 2, dans lequel au moins un élément de dissipateur thermique (11) est creux.

4. Le kit de parties selon l'une quelconque des revendications 2 à 3, dans lequel au moins un élément de dissipateur thermique (11) est un élément de dissipateur thermique à broches.

5. Le kit de parties selon l'une quelconque des revendications précédentes, dans lequel au moins une partie de dissipateur thermique (16) est creuse.

6. Le kit de parties selon l'une quelconque des revendications précédentes, dans lequel au moins une partie de dissipateur thermique (16) est un élément de dissipateur thermique à nervures.

7. Le kit de parties selon la revendication 6, dans lequel au moins une partie de dissipateur thermique (16) présente une forme ondulée.

8. Le kit de parties selon l'une quelconque des revendications précédentes, dans lequel les parties de dissipateur thermique (16) s'étendent sensiblement parallèlement.

9. Un dispositif électronique muni d'une structure de dissipateur thermique (10) et d'une structure de guidage (24, 25) selon l'une quelconque des revendications précédentes.

10. Un procédé de montage d'une structure de dissipateur thermique sur une surface d'un dispositif électronique, comprenant :
- la fourniture de la structure de dissipateur thermique, la structure de dissipateur thermique comprenant une pluralité de parties de dissipateur thermique, chaque partie de dissipateur thermique présentant une zone de contact pour entrer en contact avec la surface du dispositif électronique, les parties de dissipateur thermique étant espacées et non directement reliées entre elles ;
- la fourniture d'une structure de guidage pour positionner les parties de dissipateur thermique par rapport à la surface du dispositif électronique, la structure de guidage comprenant des ouvertures respectives pour accepter et assurer un ajustement coulissant des parties de dissipateur thermique respectives ;
- l'utilisation de la structure de guidage pour positionner les parties de dissipateur thermique de l'ensemble dissipateur thermique sur la surface du dispositif électronique.

11. Le procédé selon la revendication 10, comprenant en outre le retrait de la structure de guidage une fois que la structure de dissipateur thermique est montée sur le dispositif électronique.
